# EUROPEAN PATENT SPECIFICATION

(11) **EP 1 138 075 B1**
(45) Date of publication and mention of the grant of the patent: **26.04.2006**
(21) Application number: 99961599.0
(22) Date of filing: 04.11.1999
(51) Int. Cl.: H01L 21/8242, H01L 21/8234, H01L 21/8236, H01L 21/336, H01L 21/3205, H01L 29/94, H01L 29/76, H01L 31/062, H01L 31/113, H01L 31/119

(54) **DEVICE FOR IMPROVED SALICIDE RESISTANCE ON POLYSILICON GATES**
BAUELEMENT MIT VERBESSERTEM WIEDERSTANDSWERT DES SELBST JUSTIERTEN SILIZIDS AUF POLYSILIZIUMGATES
DISPOSITIF AMELIORANT LA RESISTANCE DU SILICIURE AUTO-ALIGNE SUR DES GRILLES EN POLYSILICIUM

(30) Priority: 13.11.1998 US 191729; 25.03.1999 US 276477
(43) Date of publication of application: 04.10.2001
(73) Proprietor: INTEL CORPORATION, Santa Clara, CA 95052 (US)
(72) Inventor: JAN, Chia-Hong, Portland, OR 97229 (US); TSAI, Julie, A., Beaverton, OR 97007 (US); YANG, Simon, Portland, OR 97229 (US); GHANI, Tahir, Beaverton, OR 97006 (US); WHITEHILL, Kevin, A., Portland, OR 97219 (US); KEATING, Steven, J., Beaverton, OR 97007 (US); MYERS, Alan, Portland, OR 97225 (US)
(74) Representative: Molyneaux, Martyn William
(86) International application number: PCT/US1999/026175
(87) International publication number: WO 2000/030174

(56) References cited:
- US-A- 4 716 131
- US-A- 4 876 213
- US-A- 4 912 061
- US-A- 5 573 965
- US-A- 5 696 012
- US-A- 5 739 573
- US-A- 5 783 479
- US-A- 5 882 973
- US-A- 5 920 783
- PATENT ABSTRACTS OF JAPAN vol. 1998, no. 13, 30 November 1998 (1998-11-30) & JP 10 223889 A (MITSUBISHI ELECTRIC CORP), 21 August 1998 (1998-08-21) & US 2002/008291 A1 (SHIMIZU ET AL.) 24 January 2002 (2002-01-24)
- PATENT ABSTRACTS OF JAPAN vol. 017, no. 657 (E-1470), 6 December 1993 (1993-12-06) & JP 05 218410 A (TOSHIBA CORP), 27 August 1993 (1993-08-27)

## Description

### FIELD OF THE INVENTION

The present invention relates to the field of semiconductor devices. More particularly, the present invention relates to a device for improved resistance on gate electrodes. Specifically, the present invention relates to a device for improved salicide resistance on polysilicon gates.

### BACKGROUND OF THE INVENTION

Transistors are commonly used in semiconductor circuitry to control current flow. For example, a transistor can be used as a switching mechanism to allow the flow of current between a source and a drain region in a circuit when a certain threshold voltage is met. Transistors generally include a gate electrode that allows or prevents the flow of current in the transistor based on applied voltage.

Figure la shows a cross-sectional view of a conventional gate electrode 100 formed on a substrate 110, the underlying structure of which is not shown. It should be noted that the figures are merely illustrative and have been simplified for clarity purposes. A thin insulative layer 120 is formed on the substrate 110 to act as a barrier between the substrate 110 and the conductive portions of the gate electrode 100. An example of an insulative layer 120 can be an oxide layer, such as silicon dioxide (SiO₂). Formed on the insulative layer 120 is a gate layer 130. An example of a gate layer 130 can be a polysilicon layer. Formed on the gate layer 130 is a conductive layer 160. An example of a conductive layer 160 can be a polycide layer, such as titanium salicide (TiSi₂). When a threshold voltage is applied to the gate layer 130 by the conductive layer 160, current will flow through the gate layer 130. Often insulative spacers 140 and 150 are formed to each side of the gate layer 130 to prevent transfer of current between the gate layer 130 and surrounding structures in the semiconductor.

In semiconductor circuit design, frequently, gate electrodes are designed in long continuous lines on the semiconductor substrate to efficiently provide current to several transistors in a circuit. Currently, improved semiconductor transistor performance is being achieved through device scaling in which the gate layer widths are being reduced from .20 µm to .15 µm and below (sub-.15) µm). As the gate layer width dimensions decrease, so do the conductive layer line widths formed above them.

When the gate layer widths decrease below.20 µm, current process techniques produce conductive lines with sharply increasing resistance. This is detrimental to the efficiency of the semiconductor, as higher resistance decreases the speed of the semiconductor circuitry. Additionally, process yields drop due to defective conductive line formation reducing manufacturing output. These problems have been particularly noted in current fabrication processes where titanium salicide (TiSi₂) is formed as the conductive layer in a polysilicon gate.

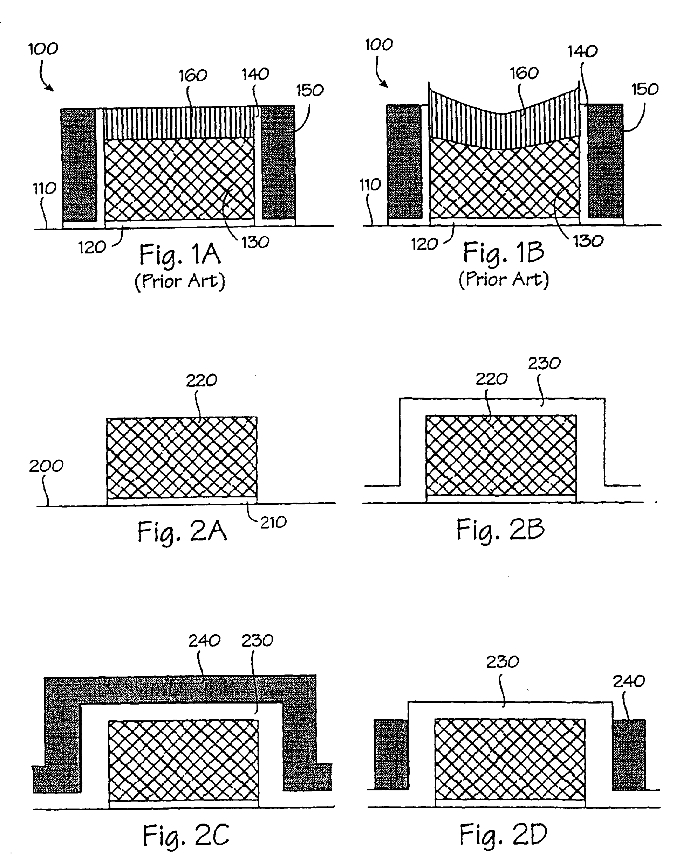

Figure 1b illustrates a cross-sectional view of a conventional gate electrode 100 formed on a substrate 110, the underlying structure of which is not shown. An example of a gate electrode 100 can be a polysilicon gate electrode. Formed on the substrate 110 is an insulative layer 120. An example of an insulative layer 120 can be an oxide. Formed on the insulative layer 120 is a conductive gate layer 130. An example of a gate layer 130 is a polysilicon layer. Formed on the gate layer 130 is a conductive layer 160. An example of a conductive layer 160 can be a polycide, such as titanium salicide. Insulative spacers 140 and 150 are formed adjacent to the gate layer 130 and conductive layer 160 to prevent current flow between the gate layer 100 and surrounding structures.

During formation of the conductive layer 160, components from underlying gate layer 130 often out diffuse into a reactant layer that is used to form the conductive layer 160. For example, silicon components of an underlying gate layer 130 may out diffuse into the conductive layer 160. This out diffusion results in a conductive layer 160 wider than the gate layer 130. When the gate layer 100 width is decreased below .20µm, the conductive layer 160 becomes stressed by its enclosure between the side walls of the spacers 140. This results in increased resistance in the conductive layer 160. Increased resistance in the conductive layer directly impacts the quality of the semiconductor circuit. The circuit becomes inefficient and circuit failure or device failure may occur.

Transistors forming the state of the art and having the foregoing problems are disclosed in US-A-5739573.

Another result of decreasing the gate line widths below .20µm is a decrease in process yields. This is due to non-formation of the conductive layer. This is attributed to the reduced reaction area, or nucleation sites, available at such small dimensions. The reduced dimensions of the gate layer reduces nucleation sites on which the conductive layer can form during processing. Using current process techniques, if suffcient nucleation sites are not provided, the conductive layer often will not form. This directly impacts the semiconductor manufacturer by reducing output.

Based on the above described problems, it would be desirable to have a device which will improve the polycide resistance in polysilicon gate widths below .20µm.

### BRIEF SUMMARY OF THE INVENTION

According to this invention there is provided a gate electrode as claimed in claim 1 herein.

The present, invention provides a device which improves polycide resistance in gate electrode widths below .20µm.

### BRIEF DISCUSSION OF THE SEVERAL VIEWS OF THE DRAWINGS

For fuller understanding of the present invention, reference is made to the accompanying drawings in the following detailed description of the invention. In the drawings:
Figure 1(a) is a cross-sectional illustration of a conventional gate electrode in the prior art depicting a non-stressed conductive layer.
Figure 1(b) is a cross-sectional illustration of a conventional gate electrode in the prior art depicting a stressed conductive layer.
Figures 2(a) - (h) are cross-sectional illustrations of the formation of a gate electrode with a conductive layer and recessed thick inner spacers and non-recessed thick outer spacers.
Figures 3(a) - (i) are cross-sectionat illustrations of the formation of a gate electrode with a conductive layer and recessed thin inner spacers and recessed thick outer spacers.
Figures 4(a) - (i) are cross-sectional illustrations of the formation of a gate electrode with a conductive layer and non-recessed thin inner spacers and partially recessed outer spacers in accordance with one embodiment of this invention.
Figures 5(a) - (m) are cross-sectional illustrations of the formation of a gate electrode with a conductive layer and two spacer stacks in accordance with another embodiment of this invention. The outermost spacer stack having recessed thin inner spacers and recessed thick outer spacers. The inner spacer stack having non-recessed thin inner spacers and non-recessed thin outer spacers.
Figures 6(a)- (p) are cross-sectional illustrations of the formation ofa gate electrode with a conductive layer and two spacer stacks. The outermost spacer stack having recessed thin inner spacers and recessed thick outer spacers. The inner spacer stack having recessed thin inner spacers and recessed thin outer spacers.

### DETAILED DESCRIPTION OF THE INVENTION

The present invention provides a device to improve polycide resistance on gate electrodes less than .20 µm in width. In the following description of the several embodiments of the invention, numerous details are set forth in order to provide a thorough understanding of the present invention. It will be appreciated by one having ordinary skill in the an that the present invention may be practiced without such specific details. In other instances well-known structures and techniques have not been described in detail in order to avoid obscuring the subject matter of the present invention. It will be understood by those having ordinary skill in the art that the structures of the present invention may be formed by various techniques.

Referring now to the drawings Figure 2a illustrates a gate layer 220 formed on a thin insulative layer 210 on a substrate 200. The gate layer 220 can be a polysilicon. The gate layer 220 can be less than .20 µm in width. These structures are formed using conventional deposition and etching techniques well-known in the art.

In Figure 2b, a thick first spacer layer 230 is deposited or grown on the gate layer 220 and substrate 200. The thick first spacer layer 230 can be an oxide. The thick first spacer layer 230 can be deposited or grown to a thickness in the range of approximately 200 - 600Å (20 - 60 nm) for example. 300Å (30 nm). It should be noted that the thick first spacer layer 230 can be deposited or grown using deposition techniques that are well known in the art and are not described in detail herein.

In Figure 2c, a thick second spacer layer 240 is deposited or grown on the thick first spacer layer 230. The thick second spacer layer 240 can be a nitride. The thick second spacer layer 240 can be deposited or grown to a thickness in the range of approximately 300 - 2000Å (30 - 200 nm) for example, 800Å (80 nm). It should be noted that the thick second spacer layer 240 can be deposited or grown using deposition techniques that are well known in the art and are not described in detail herein.

The thick second spacer layer 240 is etched to form the spacer structure illutrasted in Figure 2d. This etch is an anisotropic (directional) etch which will remove nitride, but not oxide. Examples of anisotropic etches are a dry etch or a plasma etch.

The thick first spacer layer 230 is recessed by etching to form the spacer structure illustrated in Figure 2e. The recessing creates an open space between the thick second spacer layer 240 and the gate layer 220. The thick first spacer layer 230 is etched approximately 60 nm deeper than the surface of the gate layer 220. The etching forms a space approximately 200 - 600Å (20 - 60 nm) for example, 300Å (30 nm) between the thick second spacer layer 240 and the gate layer 220. This etch is an isotropic (multidirectional) etch which will remove oxide, but not nitride. Examples of isotropic etches are dry or wet etches. It should be noted that the side walls of the gate layer 220 are now exposed creating a larger contact (reaction) surface area.

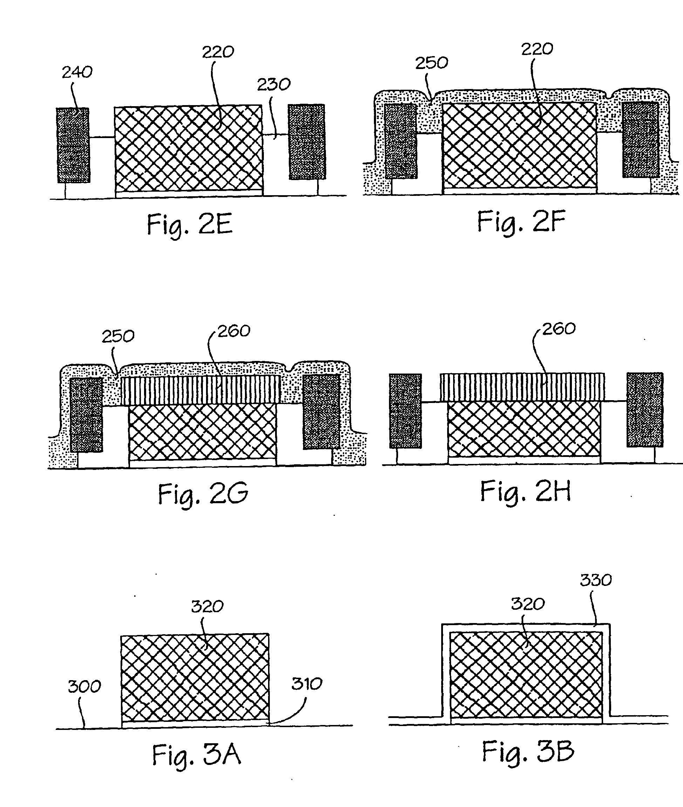

In Figure 2f, a reactant layer 250 is deposited, for example by sputter, electron beam evaporation, chemical vapor, or plasma deposition. The reactant layer 250 can be a metal, such as titanium. However, other metals, such as cobalt, nickel, tantalum and platinum may also be used. The reactant layer 250 and the gate layer 220 are then annealed to form a conductive layer 260 as shown in Figure 2g. In one embodiment, the formed conductive layer 260 can be a polycide layer, which may also be called a polysilicide layer. It should be noted that silicides can be self-aligning or non-self-aligning, and if the silicide is self-aligning, it may be called a salicide. The polycide can be titanium salicide (TiSi₂). Other polycides can be cobalt salicide (CoSi₂), nickel salicide (NiSi), tantalum salicide (TaSi), or platinum salicide (PtSi). It is to be understood by one of ordinary skill in the art that polycides, other than self-aligning silicides, may also be formed. The anneal may be performed using a rapid thermal annealing process in a nitrogen ambient. In one embodiment, additional anneals can be performed to decrease the resistance of the conductive layer 260. It is to be noted that the conductive layer 260 can now extend beyond the edges of the gate layer 220 and is not constrained and stressed by the thick first spacer layer 230.

The unreacted portion of reactant layer 250 is etched away leaving the conductive layer 260 as illustrated in Figure 2h. This etch is an isotropic etch which will remove unreacted titanium, but not titanium salicide.

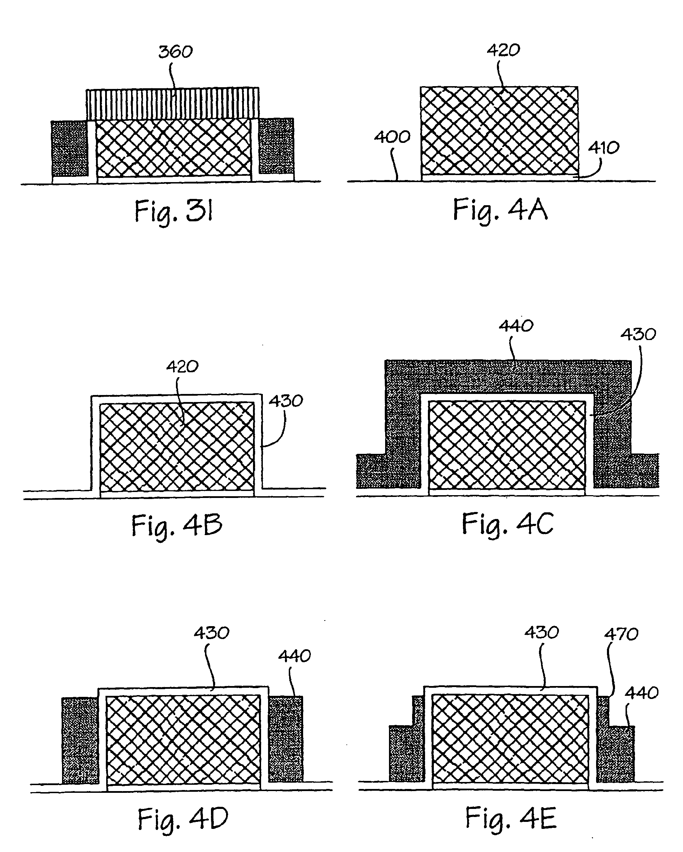

Figure 3a illustrates a gate layer 320 formed on a thin insulative layer 310 on a substrate 300. In one embodiment, the gate layer 320 can be a polysilicon. The gate layer 320 is less than .20 µm in width. These structures are formed using conventional deposition and etching techniques well-known in the art.

In Figure 3b, a thin first spacer layer 330 is deposited or grown on the gate layer 320 and substrate 300. In one embodiment, the thin first spacer layer 330 can be an oxide. The thin first spacer layer 330 is deposited or grown to a thickness in the range of approximately, 50 - 300Å (5 - 30 nm), for example, 100Å (10 nm). It should be noted that the thin first spacer layer 330 can be deposited or grown using deposition techniques that are well known in the art and are not described in detail herein.

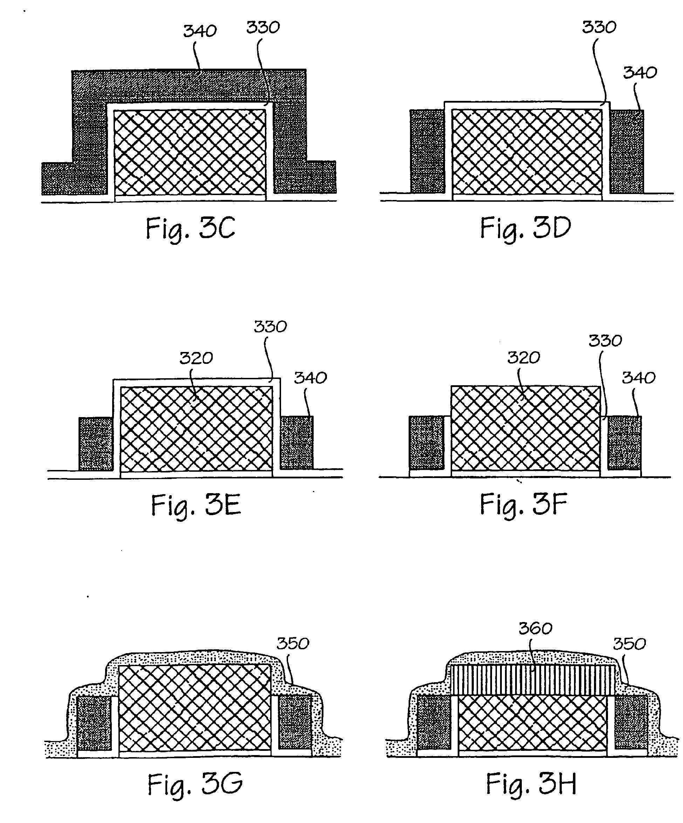

In Figure 3c, a thick second spacer layer 340 is deposited or grown on the thin first spacer layer 330. The thick second spacer layer 340 can be a nitride. The thick second spacer layer 340 is deposited or grown to a thickness in the range of approximately 300 - 2000Å (30 - 200 nm), for example, 800Å (80 nm). It should be noted that the thick second spacer layer 340 can be deposited or grown using deposition techniques that are well known in the art and are not described in detail herein.

The thick second spacer layer 340 is etched a first time to form the structure illustrated in Figure 3d. This etch is an anisotropic (directional) etch which will remove nitride, but not oxide. Examples of anisotropic etches are a dry etch or a plasma etch.

The thick second spacer layer 340 is then recessed by etching it second time to form the spacer structure illustrated in Figure 3c. The thick second spacer layer 340 is etched approximately 60 nm deeper than the surface level of the gate layer 320. In one embodiment, this etch is an isotropic (multidirectional) etch which will remove nitride, but not oxide. Examples of isotropic etches are a wet or dry etch.

The thin first spacer layer 330 is then recessed by etching to form the spacer structure illustrated in Figure 3f. This etch is an isotropic (multidirectional) etch which will remove oxide, but not nitride. Examples of isotropic etches are a dry, wet or chemical bath etch. It should further be noted that the side walls of the gate layer 320 are now exposed creating a larger contact (reaction) surface area.

In Figure 3g, a reactant layer 350 is deposited, for example, by sputter, electron beam evaporation, chemical vapor, or plasma deposition. The reactant layer 350 can be a metal, such as titanium. However, other metals, such as cobalt, nickel, tantalum and platinum may also be used.

The reactant layer 350 and the gate layer 320 are then annealed to form a conductive layer 360 as shown in Figure 3h. The formed conductive layer 360 can be a polycide, which may also be called a polysilicide layer. It should be noted that silicides can be self-aligning or non-self-aligning, and if the silicide is self-aligning, it may be called a salicide. The polycide can be titanium salicide (TiSi₂). Other polycides can be cobalt salicide (CoSi₂), nickel salicide (NiSi), tantalum salicide (TaSi), or platinum salicide (PtSi). It is to be understood by one of ordinary skill in the art that polycides, other than self-aligning silicides, may also be formed. The anneal may be performed using a rapid thermal annealing process in a nitrogen ambient. Additional anneals can be performed to decrease the resistance of the conductive layer 360. It is to be noted that the conductive layer 360 can now extend beyond the edges of thc gate layer 320 and is not constrained and stressed.

The unreacted portion of reactant layer 350 is etched away leaving the conductive layer 360 as illustrated in Figure 3i. This etch is an isotropic etch which will remove unreacted titanium, but not titanium salicide.

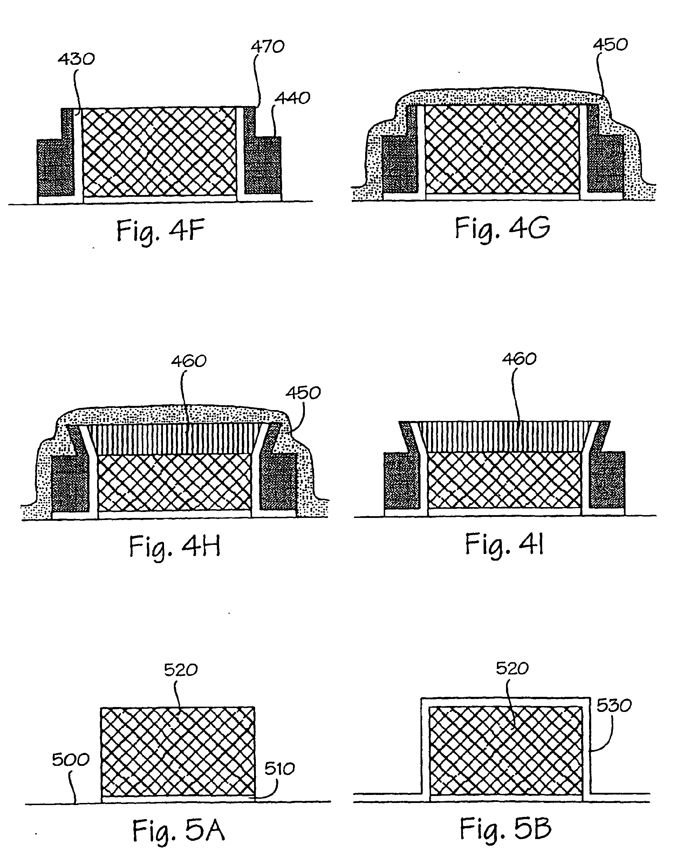

An embodiment of the present invention is illustrated in Figures 4 a - i. Figure 4a illustrates a gate layer 420 formed on a thin insulative layer 410 on a silicon substrate 400. In one embodiment, the gate layer 420 can be polysilicon. In one embodiment, the gate layer 420 is less than .20 µm in width. These structures are formed using conventional deposition and etching techniques well-known in the art.

In Figure 4b, a thin first spacer layer 430 is deposited or grown on the gate layer 420 and substrate 400. In one embodiment, the thin first spacer layer 430 can be an oxide. In one embodiment, the thin first spacer layer 430 is deposited or grown to a thickness in the range of approximately 50 - 300Å (5 - 30 nm), for example, 100Å (10 nm). It should be noted that the thin first spacer layer 430 can be deposited or grown using deposition techniques that are well known in the art and are not described in detail herein.

In Figure 4c, a thick second spacer layer 440 is deposited or grown on the thin first spacer layer 430. In one embodiment, the thick second spacer layer 440 can be a nitride. In one embodiment, the thick second spacer layer 440 can be deposited or grown to a thickness in the range of approicimately 300 - 2000Å (30 - 200 nm), for example, 800Å (80 nm). It should be noted that the thick second spacer layer 440 can be deposited or grown using deposition techniques that are well known in the art and are not described in detail herein.

The thick second spacer layer 440 is etched a first time to form the structure illustrated in Figure 4d. In one embodiment, this etch is an anisotropic (directional) etch which will remove nitride, but not oxide. Examples of anisotropic etches are a dry etch or a plasma etch.

The thick second spacer layer 440 is then partially recessed by etching a second time to form the spacer structure illustrated in Figure 4e. In one embodiment, the partial recess creates a thin second spacer wall 470 adjacent to the thin first spacer layer 430. In one embodiment, the thin second spacer wall 470 can be in the range of approximately 50 - 200Å (5 - 20 nm), for example, 100Å (10 nm), in width and can extend approximately 60 nm deeper than the surface level of the gate layer 420. In one embodiment, this etch is an anisotropic (directional) etch which will remove nitride, but not oxide. Examples of anisotropic etches are a dry etch or a plasma etch.

Following the partial recessing of the thick second spacer layer 440, the thin first spacer layer 430 is etched to form the spacer structure illustrated in Figure 4f. In one embodiment, this etch is an isotropic (multidirectional) etch which will remove oxide, but not nitride. Examples of isotropic etches are a dry, wet or chemical bath etch.

In Figure 4g, a reactant layer 450 is deposited, for example, by sputter, electron beam evaporation, chemical vapor, or plasma deposition. In one embodiment, the reactant layer 450 can be a metal, such as titanium. However, other metals, such as cobalt, nickel, tantalum and platinum may also be used.

The reactant layer 450 and the gate layer 420 are then annealed to form a conductive layer 460 as shown in Figure 4h. In one embodiment, the conductive layer 460 can be a polycide, which may also be called a polysilicide layer. It should be noted that silicides can be self-aligning or non-self-aligning, and if the silicide is self-aligning, it may be called a salicide. In one embodiment, the polycide can be titanium salicide (TiSi₂). Other polycides can be cobalt salicide (CoSi₂), nickel salicide (NiSi), tantalum salicide (TaSi), or platinum salicide (PtSi). It is to be understood by one of ordinary skill in the art that polycides, other than self-aligning silicides, may also be formed. In one embodiment, the anneal may be performed using a rapid thermal annealing process in a nitrogen ambient. In one embodiment, additional anneals can be performed to decrease the resistance of the conductive layer 460. It is to be noted that the conductive layer 460 can now extend beyond the edges of the gate layer 420 due to flexibility in the thin spacer walls formed from the thin first spacer layer 430 and the thin second spacer walls 470.

The unreacted portion of reactant layer 450 is etched away leaving the conductive layer 460 as illustrated in Figure 4i. In one embodiment, this etch is an isotropic etch which will remove unreacted titanium, but not titanium salicide.

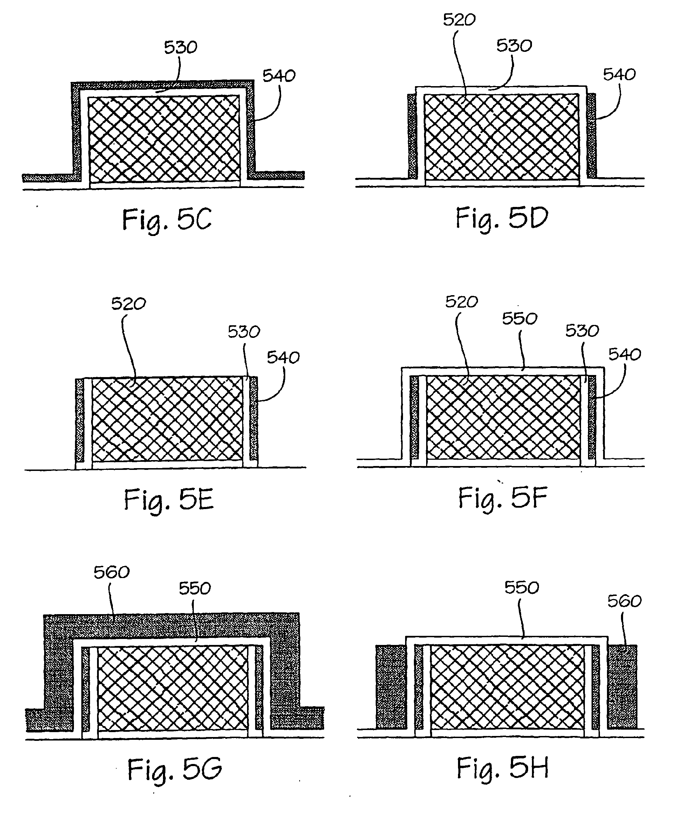

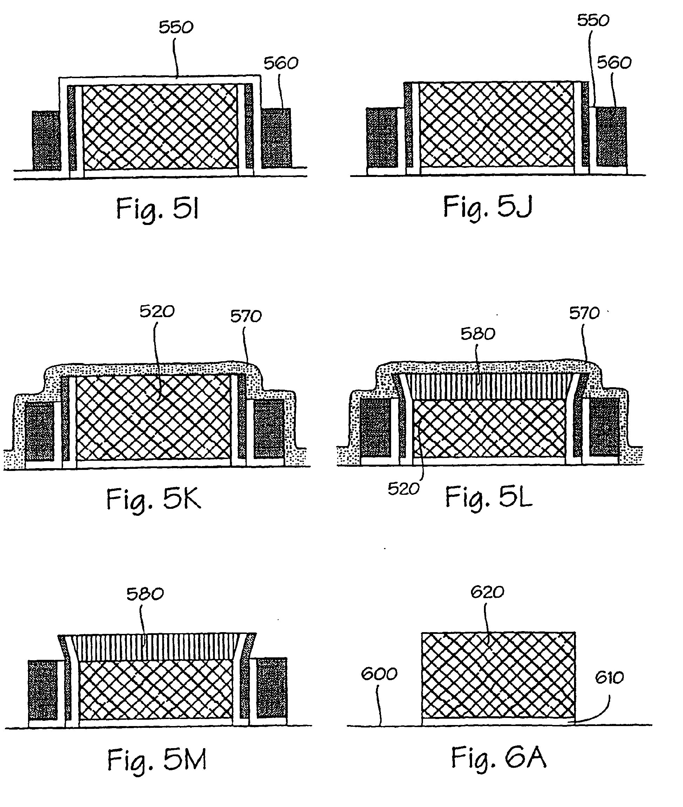

Another embodiment of the present invention is illustrated in Figures 5 a - m. Figure 5a illustrates a gate layer 520 formed on a thin insulative layer 510 on a substrate 500. In one embodiment, the gate layer 520 can be polysilicon. In one embodiment, the polysilicon gate layer 520 is less than .20 µm in width. These structures are formed using conventional deposition and etching techniques well-known in the art.

In Figure 5b, a thin first spacer layer 530 is deposited or grown on the gate layer 520 and substrate 500. In one embodiment, the thin first spacer layer 530 can be an oxide. In one embodiment, the thin first spacer layer 530 is deposited or grown to a thickness in the range of approximately 50 - 150Å (5 - 15 nm), for example, 50 Å (5 nm). It should be noted that the thin first spacer layer 530 can be deposited or grown using deposition techniques that are well known in the art and are not described in detail herein.

In Figure 5c, a thin second spacer layer 540 is deposited or grown on the thin first spacer layer 530. In one embodiment, the thin second spacer layer 540 can be a nitride. In one embodiment, the thin second spacer layer 540 can be deposited or grown to a thickness in the range of approximately 50 - 150Å (5 - 15 nm) for example, 50Å (5 nm). It should be noted that the thin second spacer layer 540 can be deposited or grown using deposition techniques that are well known in the art and are not described in detail herein.

The thin second spacer layer 540 is etched a first time to form the structure illustrated in Figure 5d. In one embodiment, this etch is an anisotropic (directional) etch which will remove nitride, but not oxide. Examples of anisotropic etches are a dry etch or a plasma etch.

Following the etch of the thin second spacer layer 540, the thin first spacer layer 530 is etched to form the structure illustrated in Figure 5e. In one embodiment, this etch is an isotropic (multidirectional) which will remove oxide, but not nitride. Examples of isotropic etches are dry or wet etches. It should be further noted that at this point in a process flow, implants of dopants can be added to the structure to enhance circuit performance.

In Figure 5f, a thin third spacer layer 550 is deposited or grown. In one embodiment, the thin third spacer layer 550 can be an oxide. In one embodiment, the thin third spacer layer 550 is deposited or grown to a thickness in the range of approximately 50 - 300Å (5 - 30 nm) for example, 100Å (10 nm). It should be noted that the thin third spacer layer 550 can be deposited or grown using deposition techniques that are well known in the art and are not described in detail herein.

In Figure 5g, a thick fourth spacer layer 560 is deposited or grown on the thin third spacer layer 550. In one embodiment, the thick fourth spacer layer 560 can be a nitride. In one embodiment, the thick fourth spacer layer 560 is deposited or grown to a thickness in the range of approximately 300 - 2000Å (30 - 200 nm) for example, 800Å (80 nm). It should be noted that the thick fourth spacer layer 560 can be deposited or grown using deposition techniques that are well known in the art and are not described in detail herein.

The thick fourth spacer layer 560 is etched a first time to form the structure illustrated in Figure 5h. In one embodiment, this etch is an anisotropic (directional) etch which will remove nitride, but not oxide. Examples of anisotropic etches are a dry etch or a plasma etch.

The thick fourth spacer layer 560 is then recessed by etching a second time to form the spacer structure illustrated in Figure 5i. In one embodiment, the thick fourth spacer layer 560 is etched approximately 60 nm deeper than the surface level of the gate layer 520. In one embodiment, this etch is an isotropic (multidirectional) etch which will remove nitride, but not oxide. Examples of isotropic etches are wet or dry etches.

The thin third spacer layer 550 is then recessed by etching to form the spacer structure illustrated in Figure 5j. In one embodiment, this etch is an isotropic (multidirectional) etch which will remove oxide, but not nitride. Examples of isotropic etches are a dry, wet or chemical bath etch.

In Figure 5k, a reactant layer 570 is deposited, for example, by sputter, electron beam evaporation, chemical vapor, or plasma deposition. In one embodiment, the reactant layer 570 can be a metal such as titanium. However, other metals, such as cobalt, nickel, tantalum and platinum may also be used.

The reactant layer 570 and the gate layer 520 are then annealed to form a conductive layer 580 as shown in Figure 5l. In one embodiment, the conductive layer 580 can be a polycide, which may also be called a polysilicide layer. It should be noted that silicides can be self-aligning or non-self-aligning, and if the silicide is self-aligning, it may be called a salicide. In one embodiment, the polycide can be titanium salicide (TiSi₂). Other polycides can be cobalt salicide (CoSi₂), nickel salicide (NiSi), tantalum salicide (TaSi), or platinum salicide (PtSi). It is to be understood by one of ordinary skill in the art that polycides, other than self-aligning silicides, may also be formed. In one embodiment, the anneal may be performed using a rapid thermal annealing process in a nitrogen ambient. In one embodiment, additional anneals can be performed to decrease the resistance of the conductive layer 580. It is to be noted that the conductive layer 580 can now extend beyond the edges of the gate layer 520 due to flexibility in the thin spacer walls formed from the thin first spacer layer 530 and the thin second spacer layer 540.

The unreacted reactant layer 570 is etched away leaving the conductive layer 580 as illustrated in Figure 5m. In one embodiment, this etch is an isotropic etch which will remove unreacted titanium, but not titanium salicide.

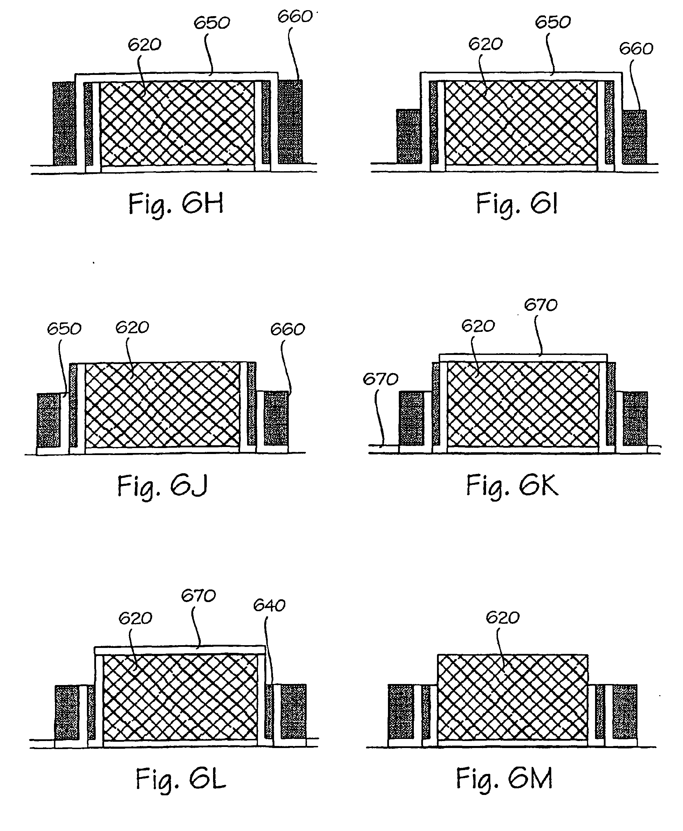

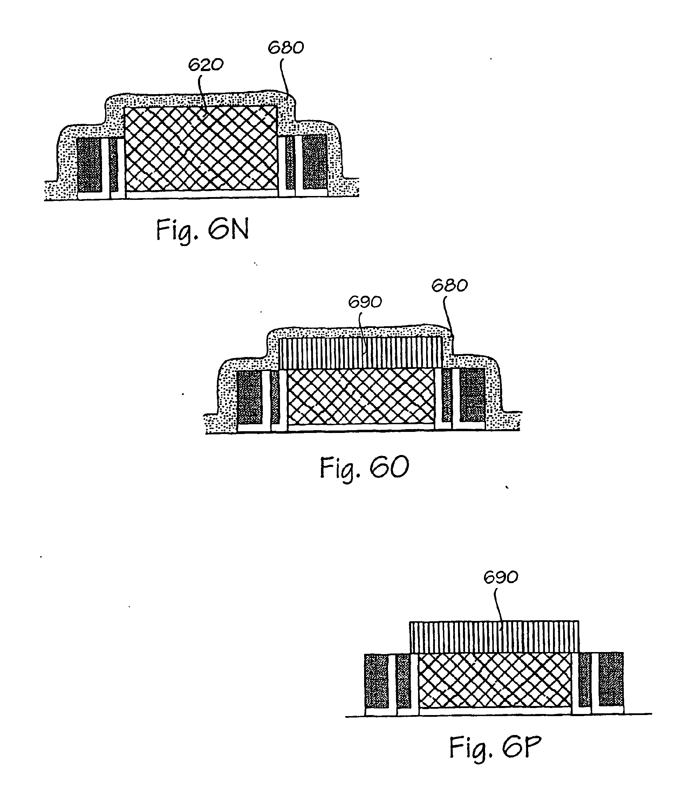

Figure 6a illustrates a gate layer 620 formed on a thin insulative layer 610 on a substrate 600. The gate layer 620 can be polysilicon. The sate layer 620 is less than .20 µm in width. These structures arc formed using conventional deposition and etching techniques well-known in the art.

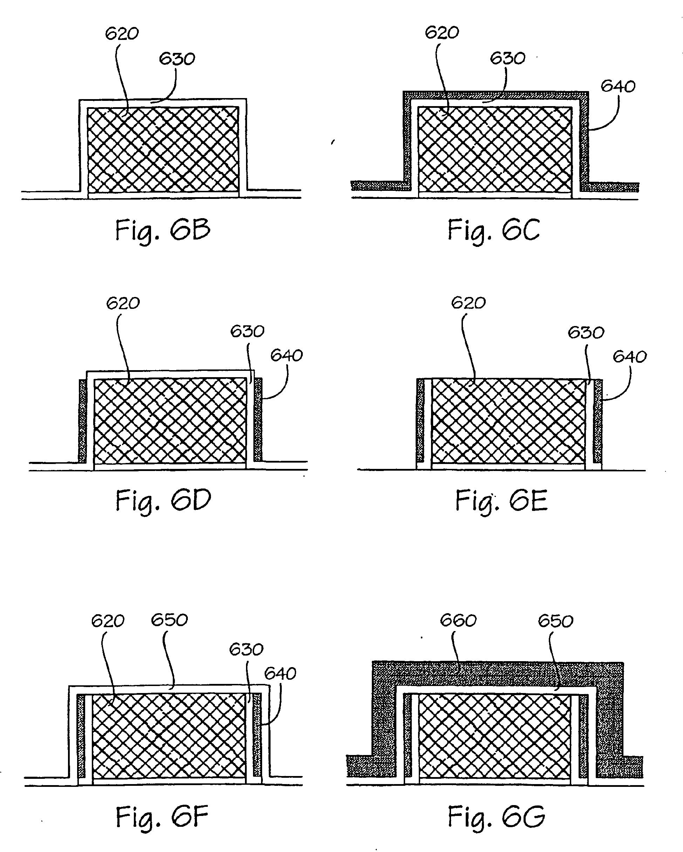

In Figure 6b, a thin first spacer layer 630 is deposited or grown on the gate layer 620 and substrate 600. The thin first spacer layer 630 can be an oxide. In one embodiment, the thin first spacer layer 630 is deposited or grown to a thickness in the range of approximately 50 - 150Å (5 - 15 nm), for example, 50Å (5 nm). It should be noted that the thin first spacer layer 630 can be deposited or grown using deposition techniques that are well known in the art and are not described in detail herein.

In Figure 6c, a thin second spacer layer 640 is deposited or grown on the thin first spacer layer 630. The thin second spacer layer 640 can be a nitride. In one embodiment, the thin second spacer layer 640 can be deposited or grown to a thickness in the range of approximately 50 - 150Å (5- 15 nm), for example, 50Å (5 nm). It should be noted that the thin second spacer layer 640 can be deposited or grown using deposition techniques that are well known in the art and are not described in detail herein.

The thin second spacer laver 640 is etched a first time to form the structure illustrated in Figure 6b. This etch is an anisotropic (directional) etch which will remove nitride, but not oxide. Examples of anisotropic etches are a dry etch or a plasma etch.

Following the etch of the thin second spacer layer 640, the thin first spacer layer 630 is etched to form the structure illustrated in Figure 6e. This etch is an isotropic (multidirectional) which will attack oxide, hut not nitride. Examples of isotropic etches are a dry, wet or chemical bath etch. It should be further noted that at this point in a process flow, implants of dopants can be added to the structure to enhance circuit performance.

In Figure 6f, a thin third spacer layer 650 is deposited or grown. The thin third spacer layer 650 can be an oxide. The thin third spacer layer 650 is deposited or grown to a thickness in the range of approximately 50 - 300Å (5 - 30 nm), for example 100Å (10 nm). It should be noted that the thin third spacer layer 650 can be deposited or grown using deposition techniques that are well known in the art and are not described in detail herein.

In Figure 6g, a thick fourth spacer layer 660 is deposited or grown on the thin third spacer layer 650. The thick fourth spacer layer 660 can be a nitride. The thick fourth spacer layer 660 is deposited or grown to a thickness in the range of approximately 300 - 2000Å (30 - 200 nm), for example, 800Å (80 nm). It should be noted that the thick fourth spacer layer 660 can be deposited or grown using deposition techniques that are well known in the art and are not described in detail herein.

The thick fourth spacer layer 660 is etched a first time to form the structure illustrated in Figure 6h. This etch is an anisotropic (directional) etch which will remove nitride, but not oxide. Examples of anisotropic etches are a dry etch or a plasma etch.

The thick fourth spacer layer 660 is then recessed by etching a second time to from the spacer structure illustrated in Figure 6i. The think fourth spacer layer 660 is etched approximately 60 nm deeper than the surface level of the gate layer 620. This etch is an isotropic (multidirectional) etch which will remove nitride, but not oxide. Examples of isotropic etches are a wet or dry etch.

The thin third spacer layer 650 is then recessed by etching to form the spacer structure illustrated in Figure 6j. This etch is an isotropic (multidirectional) etch which will remove oxide, but not nitride. Examples of isotropic etches are dry or wet etches.

At this point, further etches are still to be performed, however, the substrate 600 is left exposed. Thus, if a following etch chemistry is utilized which can remove the substrate 600, the substrate 600 will need to be protected. Thus a protective layer, for example an oxide layer, can be provided. The provision of a protective layer is described together with the figures that follow, Alternatively, if a following etch chemistry does not remove the substrate 600, then the process can continue without the necessity of providing and removing a protective layer.

In Figure 6k, a thin protective layer 670 is deposited or grown on the substrate 600. In one embodiment, the thin protective layer 670 can be oxide. The thin protective layer 670 is deposited or grown to a thickness in the range of approximately 50 - 300Å (5 - 30 nm), for example, 50Å (5 nm). The thin protective layer 670 can be an oxide grown by annealing a silicon substrate 600 in an oxygen ambient.

The thin second spacer layer 640 is recessed by etching to form the spacer structure illustrated in Figure 6l. This etch is an anisotropic (directional) etch which will remove nitride, but not oxide. Examples of anisotropic etches are a dry etch or a plasma etch.

The thin protective layer 670 is removed and the thin first spacer layer 630 recessed by etching a second time to form the spacer structure illustrated in Figure 6m. The thin first spacer layer 630 is recessed approximately 60 nm deeper than the surface level of the gate layer 620. This etch is an isotropic (multidirectional) etch which will remove oxide, hut not nitride. Examples of isotropic etches are a wet, dry or chemical bath etch. It should be noted that the side walls of the gate layer 620 are now exposed creating a larger contact (reaction) surface area.

In Figure 6n, a reactant layer 680 is deposited, for example, by sputter, electron beam evaporation, chemical vapor, or plasma deposition. The reactant layer 680 can be a metal such as titanium. However, other metals, such as cobalt, nickel, tantalum and platinum may also be used.

The reactant layer 680 and the gate layer 620 are then annealed to form a conductive layer 690 as shown in Figure 60. The conductive layer 690 can be a polycide which may also be called a polysilicide layer. It should be noted that silicides can be self-aligning or non-self-aligning, and if the silicide is self-aligning, it may be called a salicide The polycide can be titanium salicide (TiSi₂). Other polycides can be cobalt salicide (CoSi₂), nickel salicide (NiSi), tantalum salicide (TaSi), or platinum salicide (PtSi). It is to be understood by one of ordinary skill in the art that polycides, other than self-aligning silicides, may also be formed. The anneal may be performed using a rapid thermal annealing process in a nitrogen ambient. Additional anneals can be performed to decrease the resistance of the conductive, layer 690. It is to be noted that the conductive layer 690 can now extend beyond the edges of the gate layer 620 and is not constrained and stressed.

The unreacted reactant layer 680 is etched away leaving the conductive layer 690 as illustrated in Figure 6p. This is an isotropic etch which will remove unreacted titanium, but not titanium salicidc.

Through out the specification, reference has been made to isotropic and anisotropic etching. It should be noted that the present invention may be performed using these etch processes interchangeably, however, such interchanging of etch processes may cause other complications. The process steps as defined above are the preferred manner in which to perform the present invention.

Additionally, throughout the specification, it has been stated that the etch processes remove only the nitride or oxide layers, however, it should be noted that such etch processes selectively remove the nitride or oxide. In other words, an etch to remove nitride will remove nitride at a faster rate than oxide, such that more nitride is removed and very little oxide is removed, and, an etch to remove oxide will remove oxide at a faster rate than nitride, such that more oxide is removed and very little nitride is removed.

The above described embodiments of the device of the present invention provide improved polycide resistance in polysilicon gate widths below .20µm. As earlier described, conductive layers, such as the polycide titanium salicide, can expand during formation. Previous gate electrode structures had spacer structures which constrained this expansion. This led to a stressed conductive layer that exhibited increased resistance. The embodiments of the present invention, reduce the stress on the formed conductive layer thereby improving the resistance, by providing thin spacer walls which flex to dissipate stress. It is this reaction in the stress by the embodiments of the present invention, that provides improved resistance. Also, the side walls of the gate layer may be exposed to allow greater surface area. This aids in formation of the conductive layer by providing for increased nucleation sites. By aiding in formation of the conductive layer, process yields increase.

In the foregoing specification, the invention has been described with reference to specific exemplary embodiments thereof. It will, however, be evident that various modifications and changes may be made thereto without departing from the broader scope of the invention as set forth in the appended claims. The specification and drawings are, accordingly, to be regarded in an illustrative rather than a restrictive sense.

## Claims

1. A gate electrode comprising:
an insulative layer (410; 510) disposed over a substrate (400; 500);
a gate layer (420; 520) disposed over said insulative layer (410; 510);
a conductive layer (460; 560) disposed over said gate layer (420; 520) wherein said conductive layer is a polycide selected from a group consisting of cobalt, nickel, titanium, tantalum, and platinum;
first spacers (430; 530) disposed adjacent to opposite sides of said gate and conductive layers, and second spacers (440; 540) disposed adjacent to said first spacers, **characterised by** said second spacers being partially recessed, and said first spacers being thin and having upper portions which are deformed outwardly to also deform the second spacers so that the conductive layer extends outwardly beyond edges of said gate layer.

2. The gate electrode of claim 1 wherein the first spacers comprise an oxide.

3. The gate electrode of claim 2 wherein the second spacers comprise a nitride.

4. The gate electrode of claim 1 wherein said first spacers are thin so said conductive layer is not constrained or stressed.

5. The gate electrode of claim 1 wherein said second spacers are recessed lower than said conductive layer.

6. The gate electrode of claim 5 wherein the partial recess of the second spacer creates a thin second spacer wall (470; 570) adjacent to the first spacer (430; 530).

## Patentansprüche

1. Gate-Elektrode, die folgendes umfasst:
eine isolierende Schicht (410; 510), die über einem Substrat (400; 500) angeordnet ist;
eine Gate-Schicht (420; 520), die über der genannten isolierenden Schicht (410; 510) angeordnet ist;
eine leitfähige Schicht (460; 560), die über der genannten Gate-Schicht (420; 520) angeordnet ist, wobei die genannte leitfähige Schicht ein Polycid darstellt, das aus der Gruppe ausgewählt wird, die Kobalt, Nickel, Titan, Tantal und Platin umfasst;
erste Abstandselemente (430; 530), die angrenzend an gegenüberliegende Seiten der genannten Gate- und leitfähigen Schichten angeordnet sind, und zweite Abstandselemente (440; 540), die angrenzend an die genannten ersten Abstandselemente angeordnet sind, **dadurch gekennzeichnet, dass** die genannten zweiten Abstandselemente teilweise ausgespart sind, und wobei die genannten Abstandselemente dünn sind und obere Abschnitte aufweisen, die auswärts verformt werden, so dass sie die zweiten Abstandselemente verformen, so dass sich die leitfähige Schicht auswärts über die Kanten der genannten Gate-Schicht erstreckt.

2. Gate-Elektrode nach Anspruch 1, wobei die ersten Abstandselemente ein Oxid umfassen.

3. Gate-Elektrode nach Anspruch 2, wobei die zweiten Abstandselemente ein Nitrid umfassen.

4. Gate-Elektrode nach Anspruch 1, wobei die genannten ersten Abstandselemente dünn sind, so dass die genannte leitfähige Schicht nicht eingezwängt oder belastet ist.

5. Gate-Elektrode nach Anspruch 1, wobei die genannten zweiten Abstandselemente niedriger ausgespart sind als die genannte leitfähige Schicht.

6. Gate-Elektrode nach Anspruch 5, wobei die teilweise Aussparung des zweiten Abstandselements eine dünne zweite Abstandselementwand (470; 570) angrenzend an das erste Abstandselement (430; 530) erzeugt.

## Revendications

1. Electrode grille comprenant :
une couche isolante (410 ; 510) disposée sur un substrat (400 ; 500) ;
une couche grille (420 ; 520) disposée sur ladite couche isolante (410 ; 510) ;
une couche conductrice (460 ; 560) disposée sur ladite couche grille (420 ; 520) dans laquelle ladite couche conductrice est un silicium polycristallin choisi dans le groupe comprenant le cobalt, le nickel, le titane, le tantale et le platine ;
des premiers espaceurs (430 ; 530) disposés à côté de côtés opposés desdites couches grille et conductrice, et des seconds espaceurs (440 ; 540) disposés à côté desdits premiers espaceurs, **caractérisés en ce que** lesdits seconds espaceurs sont partiellement en retrait, et lesdits premiers espaceurs sont fins et ont des parties supérieures qui sont déformées vers l'extérieur pour également déformer les seconds espaceurs afin que la couche conductrice s'étende vers l'extérieur au-delà des bords de ladite couche grille.

2. Electrode grille selon la revendication 1, dans laquelle les premiers espaceurs comprennent un oxyde.

3. Electrode grille selon la revendication 2, dans laquelle les seconds espaceurs comprennent un nitrure.

4. Electrode grille selon la revendication 1, dans laquelle lesdits premiers espaceurs sont fins afin que ladite couche conductrice ne soit pas contrainte ou stressée.

5. Electrode grille selon la revendication 1, dans laquelle lesdits seconds espaceurs sont en retrait plus bas que ladite couche conductrice.

6. Electrode grille selon la revendication 5, dans laquelle le retrait partiel du second espaceur crée une paroi de second espaceur fine (470 ; 570) adjacente au premier espaceur (430 ; 530).
